# EUROPÄISCHE PATENTSCHRIFT

(11) **EP 3 795 954 B1**
(45) Veröffentlichungstag und Bekanntmachung des Hinweises auf die Patenterteilung: **01.06.2022**
(21) Anmeldenummer: 20193894.1
(22) Anmeldetag: 01.09.2020
(51) Int. Cl.: G01D 3/08, G01D 18/00

(54) **KALIBRIERBARES WERKZEUG UND VERFAHREN ZUM BETREIBEN EINES KALIBRIERBAREN WERKZEUGS**
CALIBRATABLE TOOL AND METHOD FOR OPERATING A CALIBRATABLE TOOL
OUTIL POUVANT ÊTRE ÉTALONNÉ ET PROCÉDÉ DE FONCTIONNEMENT D'UN OUTIL POUVANT ÊTRE ÉTALONNÉ

(30) Priorität: 18.09.2019 DE 102019125116
(43) Veröffentlichungstag der Anmeldung: 24.03.2021
(73) Patentinhaber: Hoffmann Engineering Services GmbH, 81241 München (DE)
(72) Erfinder: KÜNSTLER, Marko, 80634 München (DE); MEHLICH, Jens, 96479 Weitramsdorf (DE)
(74) Vertreter: Seemann & Partner Patentanwälte mbB

(56) Entgegenhaltungen:
- EP-A1- 1 867 955
- DE-A1-102004 063 468
- DE-A1-102011 050 718
- DE-A1-102014 216 560
- US-A1- 2005 263 408
- US-A1- 2013 233 043

## Beschreibung

Die Erfindung betrifft ein kalibrierbares Werkzeug und ein Verfahren zum Betreiben eines kalibrierbaren Werkzeugs.

Für kalibrierbare Werkzeuge ist es von großer Wichtigkeit, dass eine regelmäßige und präzise Kalibrierung der Werkzeuge erfolgt. So müssen beispielsweise Messwerkzeuge richtig eingestellt werden, damit die ermittelten Messgrößen den tatsächlichen Messgrößen entsprechen. Auch andere Werkzeuge, wie beispielsweise Drehmomentschraubenschlüssel, müssen kalibriert werden, damit mit den Drehmomentschlüsseln Verbindungselemente mit dem richtigen Drehmoment angezogen werden.

Eine fehlerhafte Kalibrierung eines Werkzeugs führt vielfach zu Beschädigungen. So kann sich zum Beispiel eine zu schwach angezogene Schraube frühzeitig lösen oder ein fehlerhaftes Messwerkzeug falsche Messdaten liefern. Dies ist gerade bei Arbeiten unerwünscht, die eine große Präzision erfordern.

Um zu verhindern, dass fehlerhaft kalibrierte Werkzeuge benutzt werden, müssen kalibrierbare Werkzeuge in regelmäßigen Abständen mit einer entsprechenden Kalibriervorrichtung nachkalibriert werden. Vielfach wird im Anschluss an die Kalibrierung ein Kalibrierzertifikat ausgestellt und auf das Werkzeug aufgeklebt. Ein solches Kalibrierzertifikat enthält ein nächstes Kalibrierungsdatum, bis zu dem das Werkzeug als kalibriert gilt. Stellt ein Nutzer fest oder wird der Nutzer über ein Qualitätsmanagementsystem oder sonst wie informiert, dass das nächste Kalibrierungsdatum auf einem Werkzeug, das er benutzen möchte, bereits abgelaufen ist oder demnächst abläuft, muss der Nutzer das Werkzeug vor der Nutzung nachkalibrieren.

Es ist jedoch trotz dieses Vorgehens nicht völlig auszuschließen, dass ein Werkzeug nicht mehr ausreichend kalibriert ist, obwohl das für das Werkzeug ausgestellte nächste Kalibrierungsdatum noch nicht erreicht ist. So kann es vorkommen, dass sich die Kalibrierung verändert oder die Genauigkeit des Werkzeugs unter ein akzeptables Maß fällt, wenn das Werkzeug herunterfällt oder erhöhten Temperaturen ausgesetzt ist. Da das bei der Kalibrierung erstellte nächste Kalibrierungsdatum eine solche externe Einwirkung auf das Werkzeug nicht präventiv berücksichtigen kann, besteht die Gefahr, dass ein gemäß Kalibrierzertifikat noch kalibriertes Werkzeug in Wirklichkeit falsch kalibriert ist.

EP 1 867 955 A1 zeigt ein kalibriertes medizintechnisches Instrument mit einem Umgebungssensor. Mittels des Umgebungssensors werden Umwelteinflüsse detektiert, um zu ermitteln, ob die Umwelteinflüsse die Kalibrierung oder Funktionsfähigkeit des Instruments verändern oder nicht.

In DE 10 2004 063 468 A1 ist ein Verfahren zur Funktionsüberwachung eines Sensors gezeigt. Dazu werden wiederholt Datensätze mit sensorspezifischen Kalibrierdaten erfasst, abgespeichert und eine zeitliche Entwicklung der Daten analysiert. Anhand der zeitlichen Entwicklung der Kalibrierdaten wird eine Zeit bis zur nächsten Kalibrierung des Sensors bestimmt.

DE 10 2014 216 560 A1 zeigt ein Kalibriersteuergerät zum Ankoppeln an ein Messgerät. Das Kalibriersteuergerät definiert einen Parametergrenzwert, der sich auf einen Nutzungsgrenzwert bezieht, für den das Messgerät als kalibriert zertifiziert ist. Wird der Nutzungsgrenzwert überschritten, so wird eine Kalibriergrenzwertfunktion durchgeführt.

US 2013/233043 A1 und DE 10 2011 050718 A1 offenbart jeweils ein weiteres kalibrierbares Werkzeug.

Es ist die Aufgabe der Erfindung, ein verbessertes kalibrierbares Werkzeug und ein verbessertes Verfahren zum Betreiben eines kalibrierbaren Werkzeugs anzugeben, mit denen insbesondere die Gefahr, ein fehlerhaft kalibriertes Werkzeug zu nutzen, reduziert wird. Diese Aufgabe wird gelöst durch ein kalibrierbares Werkzeug, umfassend wenigstens einen Sensor und eine Steuerungsvorrichtung, wobei auf einem Speichermedium der Steuerungsvorrichtung ein nächstes Kalibrierungsdatum des Werkzeugs gespeichert ist, wobei der wenigstens eine Sensor derart am oder im Werkzeug angeordnet ist, dass mittels des wenigstens einen Sensors externe Einwirkungen auf das Werkzeug als Messwerte messbar sind, wobei die Steuerungsvorrichtung dazu eingerichtet ist, die Messwerte des wenigstens einen Sensors zu analysieren und das nächste Kalibrierungsdatum auf ein neues, früheres Kalibrierungsdatum zu setzen, sobald der wenigstens eine Sensor einen Messwert misst, der außerhalb eines vorgebbaren Bereichs liegt.

Unter einer ersten Einwirkung auf das Werkzeug wird im Rahmen der Erfindung eine Einwirkung durch Umwelteinflüsse oder eine äußere, nicht durch den bestimmungsmäßen Gebrauch hervorgerufene oder bedingte Einwirkung verstanden.

Vorteilhaft wird das Kalibrierungsdatum des erfindungsgemäßen Werkzeugs angepasst, sobald durch eine externe Einwirkung auf das Werkzeug die Gefahr besteht, dass das Werkzeug nicht mehr richtig kalibriert ist. Dadurch wird verhindert, dass ein fehlerhaft kalibriertes Werkzeug verwendet wird.

Das nächste Kalibrierungsdatum ist ein Datum, bis zu dem das Werkzeug als kalibriert gilt. Es ist auf dem nicht flüchtigen Speichermedium der Steuerungsvorrichtung gespeichert und damit direkt auf dem Werkzeug. Dadurch ist es möglich, das Kalibrierungsdatum direkt im Werkzeug auf das neue, frühere Kalibrierungsdatum anzupassen. Bei der Festlegung des neuen, früheren Kalibrierungsdatums wird insbesondere berücksichtigt, wie stark die Kalibrierung durch die externe Einwirkung beeinträchtigt wird. Insbesondere ist das neue, frühere Kalibrierungsdatum das aktuelle Datum, also das Datum, zu dem die externe Einwirkung auftritt. Mit anderen Worten muss das Werkzeug in diesem Fall umgehend nachkalibriert werden. Dies ist insbesondere bei starken externen Einwirkungen sinnvoll, welche die Kalibrierung des Werkzeugs mit einer nicht vernachlässigbaren Wahrscheinlichkeit verändern.

Der wenigstens eine Sensor ist mit der Steuerungsvorrichtung gekoppelt. Die Messdaten des wenigstens einen Sensors werden von der Steuerungsvorrichtung kontinuierlich ausgelesen. Insbesondere misst jeder der wenigstens einen Sensoren eine unterschiedliche physikalische Größe. In diesem Fall wird für jeden Sensor ein unterschiedlicher Bereich vorgegeben, in dem Messwerte noch tolerierbar für die Beibehaltung des nächsten Kalibrierungsdatums sind.

Der obere Grenzwert des Bereichs wird so vorgegeben, dass externe Einwirkungen, die zu schwach sind, um die Kalibrierung des Werkzeugs zu verändern, als Messwerte gemessen werden, die unterhalb des oberen Grenzwerts liegen oder höchstens gleich dem oberen Grenzwert sind. Externe Einwirkungen, die stark genug sind, um die Kalibrierung des Werkzeugs zu verändern, werden demgegenüber als Messwerte gemessen, die über dem oberen Grenzwert liegen, also außerhalb des vorgebbaren Bereichs liegen. Mit anderen Worten wird für jeden Sensor der vorgebbare Bereich der Messwerte derart festgelegt, dass ein Messwert außerhalb des vorgebbaren Bereichs auf eine externe Einwirkung auf das Werkzeug hinweist, die eine Kalibrierung des Werkzeugs verändert oder eine hinreichend große Gefahr einer Veränderung der Kalibrierung besteht. Insbesondere bedeutet ein Messwert außerhalb eines für das Werkzeug vorgebbaren tolerablen Bereichs, dass der Messwert oberhalb eines oberen Grenzwerts oder unterhalb eines unteren Grenzwerts liegt.

Vorzugsweise wird das nächste Kalibrierungsdatum auf ein neues, früheres Kalibrierungsdatum gesetzt, wenn wenigstens zwei Sensoren jeweils Messwerte messen, die noch innerhalb des jeweils vorgebbaren Bereichs sind, allerdings außerhalb jeweils eines weiteren vorgebbaren Bereichs liegen.

So können beispielsweise die Messwerte von zwei Sensoren in der Nähe eines Grenzwertes liegen, aber noch im vorgebbaren Bereich und in der Kombination dazu führen, dass ein neues, früheres Kalibrierungsdatum gesetzt wird.

Der vorgebbare Bereich kann im Rahmen der Erfindung ein vorgebbarer erster Bereich sein und der vorgebbare weitere Bereich kann ein vorgebbarer zweiter Bereich sein.

Der vorgebbare Bereich kann bei bestimmten physikalischen oder chemischen Größen zu einer Seite offen sein. Für diesen Fall kann ein Grenzwert festgelegt werden und ein Überschreiten oder Unterschreiten des Grenzwerts die Folge haben, dass das nächste Kalibrierungsdatum auf ein neues, früheres Kalibrierungsdatum gesetzt wird. Beispielsweise kann ein oberer Grenzwert für eine Beschleunigung festgelegt sein, um sicher bei einer zu starken Erschütterung des Werkzeugs ein früheres nächstes Kalibrierungsdatum zu setzen.

Bevorzugt ist der wenigstens eine Sensor ein Beschleunigungssensor und/oder ein Temperatursensor und/oder ein Feuchtigkeitssensor und/oder ein Sensor zur Detektion elektromagnetischer Wellen.

Vorzugsweise ist die externe Einwirkung ein Stoß auf das Werkzeug und/oder eine Temperaturschwankung und/oder ein Auftreten von Feuchtigkeit im oder am Werkzeug und/oder elektromagnetische Wellen.

Zudem wird ein neues, früheres Kalibrierungsdatum beispielsweise gesetzt, wenn ein Stoß auf das Werkzeug wirkt, der unterhalb des Grenzwertes liegt, beispielsweise bei 80% des Grenzwertes und eine Temperatur gemessen wurde, die auch unterhalb des Grenzwertes liegt, also im vorgebbaren Bereich liegt, aber in Kombination mit dem gemessenen Stoß zu einem Setzen eines neuen, jüngeren Kalibrierungsdatums führt.

Ein Stoß auf das Werkzeug tritt beispielsweise auf, wenn das Werkzeug herunterfällt. Eine Temperaturschwankung kann z.B. durch eine Erhitzung oder insbesondere starke Abkühlung des Werkzeugs verursacht werden. Feuchtigkeit im oder am Werkzeug tritt auf, wenn das Werkzeug mit Wasser oder einer anderen Flüssigkeit in Kontakt kommt, wodurch eine Elektronik des Werkzeugs in Mitleidenschaft gezogen werden kann. Elektromagnetische Wellen wirken sich vor allem auf elektronische Bauteile des Werkzeugs aus. So kann sich die Kalibrierung des Werkzeugs beispielsweise durch starke Magnetfelder verstellen.

Um derartige externe Einwirkungen zuverlässig zu detektieren, sind Beschleunigungssensoren und/oder Temperatursensoren und/oder Feuchtigkeitssensoren und/oder Sensoren zur Detektion elektromagnetischer Wellen im oder am Werkzeug vorgesehen. Ein Sensor zur Detektion elektromagnetischer Wellen ist beispielsweise ein Hall-Sensor, mittels dem Magnetfeldstärken messbar sind.

Insbesondere umfasst das Werkzeug wenigstens zwei Sensoren, mit denen unterschiedliche physikalische oder chemische oder biologische Größen messbar sind. Beispielsweise umfasst das Werkzeug wenigstens einen Beschleunigungssensor und wenigstens einen Temperatursensor. Weiterhin umfasst das Werkzeug insbesondere wenigstens drei oder wenigstens vier Sensoren, mit denen unterschiedliche physikalische, chemische oder biologische Größen messbar sind. Dadurch werden vorteilhaft alle externen Einwirkungen auf das Werkzeug erfasst, so dass jede Einwirkung, durch die sich die Kalibrierung des Werkzeugs verändern könnte, sofort registriert und das Kalibrierungsdatum entsprechend angepasst wird.

Bevorzugt ist die Steuerungsvorrichtung dazu eingerichtet, eine Warnmeldung zu erzeugen, sobald der wenigstens eine Sensor einen Messwert misst, der außerhalb des vorgebbaren ersten Bereichs liegt, wobei die Warnmeldung insbesondere auf einer Anzeigevorrichtung des Werkzeugs angezeigt und/oder als haptisches und/oder akustisches Warnsignal am Werkzeug ausgegeben wird. Eine entsprechende Warnmeldung kann erzeugt werden, wenn Messwerte wenigstens von zwei Sensoren außerhalb der jeweiligen zweiten Bereiche liegen.

Durch die Warnmeldung wird ein Nutzer des Werkzeugs davon in Kenntnis gesetzt, dass das Werkzeug möglicherweise nicht mehr richtig kalibriert ist. Durch Anzeigen der Warnmeldung auf einer Anzeigevorrichtung lässt sich das neue, frühere Kalibrierungsdatum sofort am Werkzeug ablesen. Die Ausgabe der Warnmeldung als akustisches Signal ist insbesondere dann vorteilhaft, wenn das neue, frühere Kalibrierungsdatum dem aktuellen Datum entspricht oder abgelaufen ist, wenn also das Werkzeug umgehend rekalibriert werden muss. In diesem Fall wird durch eine akustische Warnmeldung erreicht, dass ein Nutzer von der möglichweise fehlerhaften Kalibrierung selbst dann in Kenntnis gesetzt wird, wenn er nicht auf die Anzeigevorrichtung achtet. Die haptische Warnmeldung ist beispielsweise ein kurzes Vibrieren des Werkzeugs. Eine haptische Warnmeldung wird selbst dann vom Nutzer wahrgenommen, wenn er die akustische Warnmeldung nicht wahrnimmt, beispielsweise wenn er einen Hörschutz trägt.

Gemäß einer Ausführungsform ist die Steuerungsvorrichtung dazu eingerichtet, Funktionen des Werkzeugs, die durch eine fehlerhafte Kalibrierung beeinträchtigt werden, zu sperren, sobald der wenigstens eine Sensor einen Messwert misst, der außerhalb des vorgebbaren Bereichs liegt.

Welche Funktionen gesperrt werden, hängt von der Art des Werkzeugs ab. Bei einem Messwerkzeug werden insbesondere keine Messwerte mehr angezeigt. Ein Drehmomentschraubenschlüssel dreht beispielsweise schon bei kleinsten Drehmomenten durch, so dass keine Verbindungsmittel mehr mit dem Drehmomentschraubenschlüssel angezogen werden können. So wird verhindert, dass ein Verbindungsmittel mit zu viel oder zu wenig Drehmoment angezogen wird. Die Sperrung der Funktionen wird aufgehoben, sobald das Werkzeug rekalibriert wurde.

Die Steuerungsvorrichtung ist vorzugsweise dazu eingerichtet, das neue, frühere Kalibrierungsdatum und insbesondere die Warnmeldung mittels einer Sendevorrichtung an eine externe Datenbank zu übermitteln.

Bei der externen Datenbank handelt es sich insbesondere um eine Datenbank zur Verwaltung der kalibrierbaren Werkzeuge in einem Betrieb. Auf dieser Datenbank sind insbesondere alle Kalibrierungsdaten der Werkzeuge im Betrieb gespeichert. Mittels einer mit der externen Datenbank verbundenen oder von der externen Datenbank umfassten Anzeigevorrichtung lassen sich die Kalibrierungsdaten der Werkzeuge anzeigen. Die externe Datenbank gibt insbesondere Hinweismeldungen aus, sobald ein Kalibrierungsdatum eines der Werkzeuge abgelaufen ist. Durch Übermitteln des neuen, früheren Kalibrierungsdatums an die externe Datenbank lässt sich das neue, frühere Kalibrierungsdatum nicht nur direkt am Werkzeug, sondern auch an der externen Datenbank oder an einem mit der externen Datenbank verbundenen Gerät, beispielsweise einem Computer, überprüfen.

Die Aufgabe wird zudem gelöst durch ein Verfahren zum Betreiben eines kalibrierbaren Werkzeugs, wobei auf einem Speichermedium einer Steuerungsvorrichtung des Werkzeugs ein nächstes Kalibrierungsdatum des Werkzeugs gespeichert ist, wobei mittels wenigstens eines im oder am Werkzeug angeordneten Sensors Messwerte gemessen werden, wobei für jeden Sensor ein vorgebbarer erster Bereich der Messwerte derart festgelegt wird, dass ein Messwert außerhalb des vorgebbaren ersten Bereichs auf eine externe Einwirkung auf das Werkzeug hinweist, die eine Kalibrierung des Werkzeugs verändert, wobei bei Vorliegen eines Messwerts außerhalb des vorgebbaren ersten Bereichs das nächste Kalibrierungsdatum auf ein neues, früheres Kalibrierungsdatum gesetzt wird.

Vorzugsweise werden mittels wenigstens zwei im oder am Werkzeug angeordneter Sensoren Messwerte gemessen, wobei für jeden Sensor ein vorgebbarer zweiter Bereich jeweils vorgesehen ist, der innerhalb des jeweils vorgebbaren ersten Bereichs liegt, wobei bei Vorliegen von Messwerten innerhalb des vorgebbaren ersten Bereichs und außerhalb der vorgebbaren zweiten Bereiche das nächste Kalibrierungsdatum auf ein neues, früheres Kalibrierungsdatum gesetzt wird.

Hierdurch kann ein neues, früheres Kalibrierungsdatum auch dadurch gesetzt werden, dass zwar kein Messwert außerhalb des ersten Bereichs liegt, aber wenigstens zwei Messwerte außerhalb eines jeweiligen zweiten Bereichs.

Bevorzugt ist der wenigstens eine Sensor ein Beschleunigungssensor und/oder ein Temperatursensor und/oder ein Feuchtigkeitssensor und/oder ein Sensor zur Detektion elektromagnetischer Wellen.

Vorzugsweise ist die externe Einwirkung ein Stoß auf das Werkzeug und/oder eine Temperaturschwankung und/oder ein Auftreten von Feuchtigkeit im oder am Werkzeug und/oder elektromagnetische Wellen.

Vorzugsweise wird eine Warnmeldung erzeugt, sobald der wenigstens eine Sensor einen Messwert misst, der außerhalb des vorgebbaren ersten Bereichs liegt, wobei die Warnmeldung insbesondere auf einer Anzeigevorrichtung des Werkzeugs angezeigt und/oder als haptisches und/oder akustisches Warnsignal am Werkzeug ausgegeben wird. Entsprechend wird eine Warnmeldung vorzugsweise erzeugt, wenn wenigstens zwei Sensoren Messwerte messen, die außerhalb des vorgebbaren zweiten Bereichs liegen.

Funktionen des Werkzeugs, die durch eine fehlerhafte Kalibrierung beeinträchtigt werden, werden vorzugsweise gesperrt, sobald der wenigstens eine Sensor einen Messwert misst, der außerhalb des vorgebbaren Bereichs liegt. Das Gleiche gilt bei mehreren Messwerten, die jeweils außerhalb des vorgebbaren zweiten Bereichs liegen.

Gemäß einer Ausführungsform werden das neue, frühere Kalibrierungsdatum und insbesondere die Warnmeldung mittels einer Sendevorrichtung an eine externe Datenbank übermittelt.

Im Rahmen der Erfindung sind Merkmale, die mit "insbesondere" oder "vorzugsweise" gekennzeichnet sind, als fakultative Merkmale zu verstehen.

Weitere Merkmale der Erfindung werden aus der Beschreibung erfindungsgemäßer Ausführungsformen zusammen mit den Ansprüchen und der beigefügten Zeichnung ersichtlich. Erfindungsgemäße Ausführungsformen können einzelne Merkmale oder eine Kombination mehrerer Merkmale erfüllen.

Die Erfindung wird nachstehend ohne Beschränkung des allgemeinen Erfindungsgedankens anhand von Ausführungsbeispielen unter Bezugnahme auf die Zeichnung beschrieben, wobei bezüglich aller im Text nicht näher erläuterten erfindungsgemäßen Einzelheiten ausdrücklich auf die Zeichnung verwiesen wird. Es zeigt:

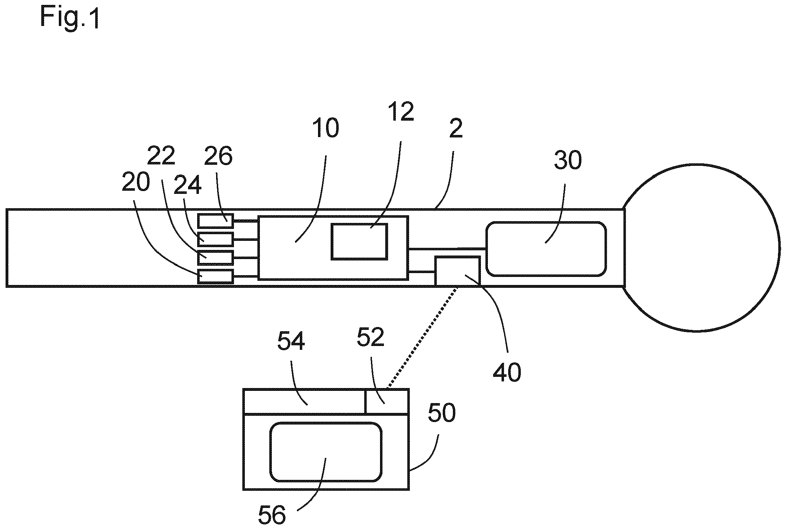

- Fig. 1: eine schematisch vereinfachte Darstellung eines kalibrierbaren Werkzeugs und einer externen Datenbank.

In der Fig. 1 ist schematisch vereinfacht ein kalibrierbares Werkzeug 2 gezeigt. Bei der in der Fig. 1 gezeigten beispielhaften Ausführungsform handelt es sich um einen Drehmomentschraubenschlüssel als Beispiel für ein kalibrierbares Werkzeug 2. Der Drehmomentschraubenschlüssel weist die üblichen Merkmale eines solchen Schraubenschlüssels auf, wie beispielsweise einen Werkzeugkopf und einen Griff, so dass auf diese Merkmale nicht weiter eingegangen werden wird.

Das Werkzeug 2 umfasst eine Steuerungsvorrichtung 10 mit einem Speichermedium 12, bei dem es sich beispielsweise um ein nicht flüchtiges Speichermedium 12 handelt. Auf dem Speichermedium 12 ist elektronisch ein nächstes Kalibrierungsdatum gespeichert, also das Datum, bis zu dem das Werkzeug 2 als kalibriert gilt. Die Steuerungsvorrichtung 10 ist zudem mit wenigstens einem Sensor 20, 22, 24, 26 verbunden. In der gezeigten Ausführungsform sind insgesamt vier Sensoren 20, 22, 24, 26 vorgesehen, ein Beschleunigungssensor 20, ein Temperatursensor 22, ein Feuchtigkeitssensor 24 und ein Sensor 26 zur Detektion elektromagnetischer Wellen. Bei dem Sensor 26 zur Detektion elektromagnetischer Wellen handelt es sich beispielsweise um einen Hall-Sensor. Ein Hall-Sensor ist sinnvoll, wenn das Werkzeug 2 empfindlich auf magnetische Felder reagiert oder in der Nähe starker magnetischer Felder eingesetzt wird.

Die Sensoren 20, 22, 24, 26 messen Messwerte von physikalischen und/oder chemischen Größen, beispielsweise der Beschleunigung, der Temperatur, der Feuchtigkeit und der Stärke von elektromagnetischen Wellen, denen das Werkzeug 2 ausgesetzt ist. Für jeden Sensor 20, 22, 24, 26 wird ein Bereich für Messwerte festgelegt. Der Bereich wird so gewählt, dass ein Messwert außerhalb des Bereichs auf eine externe Einwirkung hinweist, die so groß ist, dass die Kalibrierung des Werkzeugs 2 beeinträchtigt sein könnte. Dies ist beispielsweise bei einem Sturz, einer großen Temperaturschwankung oder einem Eindringen von Feuchtigkeit in das Werkzeug der Fall. Bei einer Kombination von Messwerten verschiedener Sensoren können auch geringere Beeinträchtigungen von einzelnen Messwerten in der Summe zu einer gesamten Beeinträchtigung führen, die zu einer Veränderung eines Kalibrierungsdatums führen kann.

Die Sensoren 20, 22, 24, 26 übermitteln die von ihnen gemessenen Messwerte kontinuierlich an die Steuerungsvorrichtung 10, welche die Messwerte mit den Grenzwerten bzw. dem vorgebbaren Bereich für die jeweiligen Sensoren 20, 22, 24, 26 vergleicht. Überschreitet einer der gemessenen Messwerte den für den jeweiligen Sensor 20, 22, 24, 26 festgelegten Grenzwert oder liegt ein Messwert außerhalb des vorgebbaren Bereichs, so ändert die Steuerungsvorrichtung 10 das Kalibrierungsdatum auf dem Speichermedium 12 zu einem früher liegenden Kalibrierungsdatum. Beispielsweise ändert die Steuerungsvorrichtung 10 das nächste Kalibrierungsdatum auf das aktuelle Datum. Mit anderen Worten muss das Werkzeug 2 in diesem Fall direkt nach der externen Einwirkung nachkalibriert werden.

Das geänderte Kalibrierungsdatum wird beispielsweise auf einer Anzeigevorrichtung 30 angezeigt. Zusätzlich oder alternativ gibt das Werkzeug 2 ein haptisches oder akustisches Signal aus, um anzuzeigen, dass es rekalibriert werden muss. Um zu verhindern, dass mit einem fehlerhaft kalibrierten Werkzeug 2 weiter gearbeitet wird, werden gemäß einer Ausführungsform Funktionen, die durch eine fehlerhafte Kalibrierung beeinträchtigt werden, gesperrt, sobald einer der Grenzwerte überschritten wird. Eine solche Sperrung kann bei dem in Fig. 1 beispielhaft dargestellten Drehmomentschraubenschlüssel z.B. darin bestehen, dass der Schraubenschlüssel bei jedem Drehmoment durchrutscht, so dass ein Anziehen von Verbindungsmitteln mit dem Drehmomentschraubenschlüssel nicht mehr möglich ist, bis der Drehmomentschraubenschlüssel rekalibriert wurde.

Das in Fig. 1 dargestellte Werkzeug 2 umfasst in der dargestellten Ausführungsform zudem eine Sendevorrichtung 40. Diese übermittelt, beispielsweise drahtlos, das geänderte Kalibrierungsdatum und insbesondere auch die Warnmeldung an eine Empfangsvorrichtung 52 einer externen Datenbank 50. Die externe Datenbank 50 ist z.B. zur Verwaltung aller kalibrierbaren Werkzeuge 2 in einem Betrieb vorgesehen. Auf einem Speichermedium 54 der externen Datenbank 50 sind alle Kalibrierungsdaten der Werkzeuge 2 im Betrieb gespeichert. Empfängt die Empfangsvorrichtung 52 das geänderte Kalibrierungsdatum, wird ein entsprechender Eintrag in dem Speichermedium 54 der Datenbank 50 aktualisiert. Zusätzlich wird die Warnmeldung auf einer Anzeigevorrichtung 56 ausgegeben, die mit der externen Datenbank 50 verbunden oder Teil der externen Datenbank 50 ist. Auf diese Weise wird ein Nutzer der externen Datenbank 50 umgehend informiert, wenn das Werkzeug 2 nachkalibriert werden muss.

### Bezugszeichenliste

- 2: Werkzeug
- 10: Steuerungsvorrichtung
- 12: nicht flüchtiges Speichermedium
- 20: Sensor
- 22: Sensor
- 24: Sensor
- 26: Sensor
- 30: Anzeigevorrichtung
- 40: Sendevorrichtung
- 50: externe Datenbank
- 52: Empfangsvorrichtung
- 54: nicht flüchtiges Speichermedium
- 56: Anzeigevorrichtung

## Patentansprüche

1. Kalibrierbares Werkzeug (2), umfassend wenigstens einen Sensor (20, 22, 24, 26) und eine Steuerungsvorrichtung (10), wobei auf einem Speichermedium (12) der Steuerungsvorrichtung (10) ein nächstes Kalibrierungsdatum des Werkzeugs (2) gespeichert ist, wobei der wenigstens eine Sensor (20, 22, 24, 26) derart am oder im Werkzeug (2) angeordnet ist, dass mittels des wenigstens einen Sensors (20, 22, 24, 26) externe Einwirkungen auf das Werkzeug (2) als Messwerte messbar sind, wobei die Steuerungsvorrichtung (10) dazu eingerichtet ist, die Messwerte des wenigstens einen Sensors zu analysieren und das nächste Kalibrierungsdatum auf ein neues, früheres Kalibrierungsdatum zu setzen, sobald der wenigstens eine Sensor (20, 22, 24, 26) einen Messwert misst, der außerhalb eines vorgebbaren Bereichs liegt.

2. Werkzeug (2) nach Anspruch 1, **dadurch gekennzeichnet, dass** die Steuerungsvorrichtung (10) dazu eingerichtet ist, die Messwerte von wenigstens zwei Sensoren zu analysieren und das nächste Kalibrierungsdatum auf ein neues, früheres Kalibrierungsdatum zu setzen, wenn die wenigstens zwei Sensoren jeweils Messwerte messen, die noch innerhalb des jeweils vorgebbaren Bereichs sind, allerdings außerhalb jeweils eines weiteren vorgebbaren Bereichs liegen.

3. Werkzeug (2) nach Anspruch 1 oder 2, **dadurch gekennzeichnet, dass** der wenigstens eine Sensor (20, 22, 24, 26) ein Beschleunigungssensor (20) und/oder ein Temperatursensor (22) und/oder ein Feuchtigkeitssensor (24) und/oder ein Sensor (26) zur Detektion elektromagnetischer Wellen ist.

4. Werkzeug (2) nach einem der Ansprüche 1 bis 3, **dadurch gekennzeichnet, dass** die externe Einwirkung ein Stoß auf das Werkzeug (2) und/oder eine Temperaturschwankung und/oder ein Auftreten von Feuchtigkeit im oder am Werkzeug (2) und/oder elektromagnetische Wellen ist.

5. Werkzeug (2) nach einem der Ansprüche 1 bis 4, **dadurch gekennzeichnet, dass** die Steuerungsvorrichtung (10) dazu eingerichtet ist, eine Warnmeldung zu erzeugen, sobald der wenigstens eine Sensor (20, 22, 24, 26) einen Messwert misst, der außerhalb des vorgebbaren Bereichs liegt, wobei die Warnmeldung insbesondere auf einer Anzeigevorrichtung (30) des Werkzeugs (2) angezeigt und/oder als haptisches und/oder akustisches Warnsignal am Werkzeug (2) ausgegeben wird.

6. Werkzeug (2) nach einem der Ansprüche 1 bis 5, **dadurch gekennzeichnet, dass** die Steuerungsvorrichtung (10) dazu eingerichtet ist, Funktionen des Werkzeugs (2), die durch eine fehlerhafte Kalibrierung beeinträchtigt werden, zu sperren, sobald der wenigstens eine Sensor (20, 22, 24, 26) einen Messwert misst, der außerhalb des vorgebbaren Bereichs liegt.

7. Werkzeug (2) nach einem der Ansprüche 1 bis 6, **dadurch gekennzeichnet, dass** die Steuerungsvorrichtung (10) dazu eingerichtet ist, das neue, frühere Kalibrierungsdatum und insbesondere die Warnmeldung mittels einer Sendevorrichtung (40) an eine externe Datenbank (50) zu übermitteln.

8. Verfahren zum Betreiben eines kalibrierbaren Werkzeugs (2), wobei auf einem Speichermedium (12) einer Steuerungsvorrichtung (10) des Werkzeugs (2) ein nächstes Kalibrierungsdatum des Werkzeugs (2) gespeichert ist, wobei mittels wenigstens eines im oder am Werkzeug (2) angeordneten Sensors (20, 22, 24, 26) Messwerte gemessen werden, wobei für jeden Sensor (20, 22, 24, 26) ein vorgebbarer erster Bereich der Messwerte derart festgelegt wird, dass ein Messwert außerhalb des vorgebbaren ersten Bereichs auf eine externe Einwirkung auf das Werkzeug (2) hinweist, die eine Kalibrierung des Werkzeugs (2) verändert, wobei bei Vorliegen eines Messwerts außerhalb des vorgebbaren ersten Bereichs das nächste Kalibrierungsdatum auf ein neues, früheres Kalibrierungsdatum gesetzt wird.

9. Verfahren nach Anspruch 8, **dadurch gekennzeichnet, dass** mittels wenigstens zwei im oder am Werkzeug (2) angeordneter Sensoren (20, 22, 24, 26) Messwerte gemessen werden, wobei für jeden Sensor (20, 22, 24, 26) ein vorgebbarer zweiter Bereich jeweils vorgesehen ist, der innerhalb des jeweils vorgebbaren ersten Bereichs liegt, wobei bei Vorliegen von Messwerten innerhalb des vorgebbaren ersten Bereichs und außerhalb der vorgebbaren zweiten Bereiche das nächste Kalibrierungsdatum auf ein neues, früheres Kalibrierungsdatum gesetzt wird.

10. Verfahren nach Anspruch 8 oder 9, **dadurch gekennzeichnet, dass** der wenigstens eine Sensor (20, 22, 24, 26) ein Beschleunigungssensor (20) und/oder ein Temperatursensor (22) und/oder ein Feuchtigkeitssensor (24) und/oder ein Sensor (26) zur Detektion elektromagnetischer Wellen ist.

11. Verfahren nach einem der Ansprüche 8 bis 10, **dadurch gekennzeichnet, dass** die externe Einwirkung ein Stoß auf das Werkzeug (2) und/oder eine Temperaturschwankung und/oder ein Auftreten von Feuchtigkeit im oder am Werkzeug (2) und/oder elektromagnetische Wellen ist.

12. Verfahren nach einem der Ansprüche 8 bis 11, **dadurch gekennzeichnet, dass** eine Warnmeldung erzeugt wird, sobald der wenigstens eine Sensor (20, 22, 24, 26) einen Messwert misst, der außerhalb des vorgebbaren Bereichs liegt, wobei die Warnmeldung insbesondere auf einer Anzeigevorrichtung (30) des Werkzeugs (2) angezeigt und/oder als haptisches und/oder akustisches Warnsignal am Werkzeug (2) ausgegeben wird.

13. Verfahren nach einem der Ansprüche 8 bis 12, **dadurch gekennzeichnet, dass** Funktionen des Werkzeugs (2), die durch eine fehlerhafte Kalibrierung beeinträchtigt werden, gesperrt werden, sobald der wenigstens eine Sensor (20, 22, 24, 26) einen Messwert misst, der außerhalb des vorgebbaren Bereichs liegt.

14. Verfahren nach einem der Ansprüche 8 bis 13, **dadurch gekennzeichnet, dass** das neue, frühere Kalibrierungsdatum und insbesondere die Warnmeldung mittels einer Sendevorrichtung (40) an eine externe Datenbank (50) übermittelt werden.

## Claims

1. A calibratable tool (2) comprising at least one sensor (20, 22, 24, 26) and a control device (10), wherein a next calibration date of the tool (2) is stored on a storage medium (12) of the control device (10), wherein the at least one sensor (20, 22, 24, 26) is arranged on or in the tool (2) such that external effects on the tool (2) are measurable as measured values by means of the at least one sensor (20, 22, 24, 26), wherein the control device (10) is designed to analyze the measured values of the at least one sensor and to set the next calibration date to a new, earlier calibration date as soon as the at least one sensor (20, 22, 24, 26) measures a measured value which is outside a predeterminable range.

2. The tool (2) according to claim 1, **characterized in that** the control device (10) is designed to analyze the measured values of at least two sensors and to set the next calibration date to a new, earlier calibration date when the at least two sensors respectively measure measured values which are still within the respectively predeterminable range but are respectively outside a further predeterminable range.

3. The tool (2) according to claim 1 or 2, **characterized in that** the at least one sensor (20, 22, 24, 26) is an acceleration sensor (20) and/or a temperature sensor (22) and/or a humidity sensor (24) and/or a sensor (26) for detecting electromagnetic waves.

4. The tool (2) according to one of claims 1 to 3, **characterized in that** the external effect is an impact on the tool (2) and/or a temperature fluctuation and/or an occurrence of moisture in or on the tool (2) and/or electromagnetic waves.

5. The tool (2) according to one of claims 1 to 4, **characterized in that** the control device (10) is designed to generate a warning message as soon as the at least one sensor (20, 22, 24, 26) measures a measured value which is outside the predeterminable range, wherein the warning message is displayed, in particular, on a display device (30) of the tool (2) and/or is output as a haptic and/or acoustic warning signal on the tool (2).

6. The tool (2) according to one of claims 1 to 5, **characterized in that** the control device (10) is designed to block functions of the tool (2) which are impaired by a faulty calibration as soon as the at least one sensor (20, 22, 24, 26) measures a measured value which is outside the predeterminable range.

7. The tool (2) according to one of claims 1 to 6, **characterized in that** the control device (10) is designed to transmit the new, earlier calibration date and, in particular, the warning message by means of a transmitting device (40) to an external database (50) .

8. A method for operating a calibratable tool (2), wherein a next calibration date of the tool (2) is stored on a storage medium (12) of a control device (10) of the tool (2), wherein measured values are measured by means of at least one sensor (20, 22, 24, 26) which is arranged in or on the tool (2), wherein a predeterminable first range of the measured values is fixed for each sensor (20, 22, 24, 26) such that a measured value which is outside the predeterminable first range indicates an external effect on the tool (2) which changes a calibration of the tool (2), wherein with the presence of a measured value which is outside the predeterminable first range, the next calibration date is set to a new, earlier calibration date.

9. The method according to claim 8, **characterized in that** measured values are measured by means of at least two sensors (20, 22, 24, 26) which are arranged in or on the tool (2), wherein a predeterminable second range which is within the respectively predeterminable first range is respectively provided for each sensor (20, 22, 24, 26), wherein with the presence of measured values which are within the predeterminable first range and outside the predeterminable second range, the next calibration date is set to a new, earlier calibration date.

10. The method according to claim 8 or 9, **characterized in that** the at least one sensor (20, 22, 24, 26) is an acceleration sensor (20) and/or a temperature sensor (22) and/or a humidity sensor (24) and/or a sensor (26) for detecting electromagnetic waves.

11. The method according to one of claims 8 to 10, **characterized in that** the external effect is an impact on the tool (2) and/or a temperature fluctuation and/or an occurrence of moisture in or on the tool (2) and/or electromagnetic waves.

12. The method according to one of claims 8 to 11, **characterized in that** a warning message is generated as soon as the at least one sensor (20, 22, 24, 26) measures a measured value which is outside the predeterminable range, wherein the warning message is displayed, in particular, on a display device (30) of the tool (2) and/or is output as a haptic and/or acoustic warning signal on the tool (2).

13. The method according to one of claims 8 to 12, **characterized in that** functions of the tool (2), which are impaired by a faulty calibration, are blocked as soon as the at least one sensor (20, 22, 24, 26) measures a measured value which is outside the predeterminable range.

14. The method according to one of claims 8 to 13, **characterized in that** the new, earlier calibration date and, in particular, the warning message are transmitted by means of a transmitting device (40) to an external database (50).

## Revendications

1. Outil (2) apte à être étalonné, comprenant au moins un capteur (20, 22, 24, 26) et un dispositif de commande (10), dans lequel une date d'étalonnage prochaine de l'outil (2) est enregistrée sur un support de stockage (12) du dispositif de commande (10), ledit au moins un capteur (20, 22, 24, 26) étant disposé sur ou dans l'outil (2) de telle sorte qu'au moyen dudit au moins un capteur (20, 22, 24, 26), des actions externes sur l'outil (2) puissent être mesurées en tant que valeurs de mesure, le dispositif de commande (10) étant conçu pour analyser les valeurs mesurées dudit au moins un capteur et pour fixer la prochaine date d'étalonnage à une nouvelle date d'étalonnage plus rapprochée, dès que ledit au moins un capteur (20, 22, 24, 26) mesure une valeur de mesure qui se situe en dehors d'une plage prédéterminable.

2. Outil (2) selon la revendication 1, **caractérisé en ce que** le dispositif de commande (10) est conçu pour analyser les valeurs mesurées d'au moins deux capteurs et pour fixer la prochaine date d'étalonnage à une nouvelle date d'étalonnage plus rapprochée lorsque lesdits au moins deux capteurs mesurent chacun des valeurs mesurées qui sont encore à l'intérieur de la plage respective apte à être prédéfinie, mais qui se situent chacune en dehors d'une autre plage prédéterminable.

3. Outil (2) selon la revendication 1 ou la revendication 2, **caractérisé en ce que** ledit au moins un capteur (20, 22, 24, 26) est un capteur d'accélération (20) et/ou un capteur de température (22) et/ou un capteur d'humidité (24) et/ou un capteur (26) pour la détection d'ondes électromagnétiques.

4. Outil (2) selon l'une des revendications 1 à 3, **caractérisé en ce que** l'action externe est un choc sur l'outil (2) et/ou une variation de température et/ou une apparition d'humidité dans ou sur l'outil (2) et/ou d'ondes électromagnétiques.

5. Outil (2) selon l'une des revendications 1 à 4, **caractérisé en ce que** le dispositif de commande (10) est agencé de façon à générer un message d'alerte dès que ledit au moins un capteur (20, 22, 24, 26) mesure une valeur de mesure qui se situe en dehors de la plage prédéterminable, le message d'alerte étant notamment affiché sur un dispositif d'affichage (30) de l'outil (2) et/ou émis sous forme de signal d'alerte haptique et/ou sonore sur l'outil (2).

6. Outil (2) selon l'une des revendications 1 à 5, **caractérisé en ce que** le dispositif de commande (10) est configuré de façon à bloquer les fonctions de l'outil (2) qui sont affectées par un étalonnage défectueux, dès que ledit au moins un capteur (20, 22, 24, 26) mesure une valeur de mesure qui se situe en dehors de la plage prédéterminable.

7. Outil (2) selon l'une des revendications 1 à 6, **caractérisé en ce que** le dispositif de commande (10) est conçu de façon à transmettre la nouvelle date d'étalonnage plus rapprochée et notamment le message d'alerte à une base de données externe (50) au moyen d'un dispositif d'émission (40).

8. Procédé d'exploitation d'un outil (2) apte être étalonné, une prochaine date d'étalonnage de l'outil (2) étant enregistrée sur un support de mémoire (12) d'un dispositif de commande (10) de l'outil (2), des valeurs de mesure étant mesurées au moyen d'au moins un capteur (20, 22, 24, 26) disposé dans ou sur l'outil (2), une première plage prédéterminable des valeurs mesurées étant définie pour chaque capteur (20, 22, 24, 26) de telle sorte qu'une valeur mesurée située en dehors de la première plage prédéterminable indique une action externe sur l'outil (2) qui modifie un étalonnage de l'outil (2), la prochaine date d'étalonnage étant fixée à une nouvelle date d'étalonnage plus rapprochée en présence d'une valeur mesurée qui se situe en dehors de la première plage prédéterminable.

9. Procédé selon la revendication 8, **caractérisé en ce que** des valeurs de mesure sont mesurées au moyen d'au moins deux capteurs (20, 22, 24, 26) disposés dans ou sur l'outil (2), une deuxième plage prédéterminable étant prévue pour chaque capteur (20, 22, 24, 26), laquelle se situe à l'intérieur de la première plage prédéterminable respective, la prochaine date d'étalonnage étant fixée à une nouvelle date d'étalonnage plus rapprochée en présence de valeurs mesurées situées à l'intérieur de la première plage prédéterminable et à l'extérieur des deuxièmes plages prédéterminables.

10. Procédé selon la revendication 8 ou la revendication 9, **caractérisé en ce que** ledit au moins un capteur (20, 22, 24, 26) est un capteur d'accélération (20) et/ou un capteur de température (22) et/ou un capteur d'humidité (24) et/ou un capteur (26) de détection d'ondes électromagnétiques.

11. Procédé selon l'une des revendications 8 à 10, **caractérisé en ce que** l'action externe est un choc sur l'outil (2) et/ou une variation de température et/ou une apparition d'humidité dans ou sur l'outil (2) et/ou d'ondes électromagnétiques.

12. Procédé selon l'une des revendications 8 à 11, **caractérisé en ce qu'**un message d'alerte est généré dès que ledit au moins un capteur (20, 22, 24, 26) mesure une valeur de mesure située en dehors de la plage prédéterminable, le message d'alerte étant notamment affiché sur un dispositif d'affichage (30) de l'outil (2) et/ou émis sous forme de signal d'alerte haptique et/ou sonore sur l'outil (2).

13. Procédé selon l'une des revendications 8 à 12, **caractérisé en ce que** les fonctions de l'outil (2) qui sont affectées par un étalonnage défectueux sont bloquées dès que ledit au moins un capteur (20, 22, 24, 26) mesure une valeur de mesure qui se situe en dehors de la plage prédéterminable.

14. Procédé selon l'une des revendications 8 à 13, **caractérisé en ce que** la nouvelle date d'étalonnage plus rapprochée, et notamment le message d'avertissement, est transmise à une base de données externe (50) au moyen d'un dispositif d'émission (40).
